# EUROPEAN PATENT SPECIFICATION

(11) **EP 4 168 785 B1**
(45) Date of publication and mention of the grant of the patent: **05.08.2026**
(21) Application number: 21736376.1
(22) Date of filing: 17.06.2021
(51) Int. Cl.: G01N 24/10, G01R 33/30

(54) **METHOD FOR ELECTRON PARAMAGNETIC RESONANCE IN VIVO STUDY, SYSTEM AND FLAT CELL CAPILLARY FOR USE IN THIS METHOD**
VERFAHREN ZUR UNTERSUCHUNG MITTELS PARAMAGNETISCHER ELEKTRONENRESONANZ IN VIVO, SYSTEM UND FLACHZELLENKAPILLARE ZUR VERWENDUNG IN DIESEM VERFAHREN
PROCÉDÉ D'ÉTUDE DE RÉSONANCE PARAMAGNÉTIQUE ÉLECTRONIQUE IN VIVO, SYSTÈME ET CAPILLAIRE CELLULAIRE PLAT POUR L'UTILISATION DANS LE PROCÉDÉ

(30) Priority: 18.06.2020 PL 43437020
(43) Date of publication of application: 26.04.2023
(73) Proprietor: Warszawski Uniwersytet Medyczny, 02-091 Warszawa (PL)
(72) Inventor: MAKAROVA, Katerina, 02-400 Warszawa (PL); ZAWADA, Katarzyna, 03-536 Warszawa (PL)
(74) Representative: Patpol Kancelaria Patentowa Sp. z o.o.
(86) International application number: PCT/IB2021/055356
(87) International publication number: WO 2021/255683

(56) References cited:
- US-A1- 2005 288 573
- US-A1- 2009 066 333
- LAB GLASS WILMAD: "EPR Consumables and Accessories", 2011, XP055698617, Retrieved from the Internet <URL:http://www.armar.ch/wp-content/uploads/2014/01/7bca6c76c6b186381c68e0de570284c6-Kopie.pdf> [retrieved on 20200526]
- SIVARAM VEERAMANI ET AL: "Shell-bound iron dependant nitric oxide synthesis in encysted Artemia parthenogenetica embryos during hydrogen peroxide exposure", BIOMETALS, KLUWER ACADEMIC PUBLISHERS, BO, vol. 24, no. 6, 22 May 2011 (2011-05-22), pages 1035 - 1044, XP019977387, ISSN: 1572-8773, DOI: 10.1007/S10534-011-9462-1
- MERRIFIELD GAVIN D ET AL: "Rapid and recoverable in vivo magnetic resonance imaging of the adult zebrafish at 7T", MAGNETIC RESONANCE IMAGING, ELSEVIER SCIENCE, TARRYTOWN, NY, US, vol. 37, 14 October 2016 (2016-10-14), pages 9 - 15, XP029920648, ISSN: 0730-725X, DOI: 10.1016/J.MRI.2016.10.013
- PEDERSEN J Z ET AL: "Use of flat glass capillaries as ESR aqueous sample cells", JOURNAL OF MAGNETIC RESONANCE, ACADEMIC PRESS, LONDON, GB, vol. 77, no. 2, April 1988 (1988-04-01), pages 369 - 371, XP023958422, ISSN: 0022-2364, [retrieved on 19880401], DOI: 10.1016/0022-2364(88)90186-2
- MADER K ET AL: "Detection of free radicals in living mice after inhalation of DTBN by X-band ESR", FREE RADICAL BIOLOGY & MEDICINE, ELSEVIER INC, US, vol. 14, no. 3, March 1993 (1993-03-01), pages 339 - 342, XP023522167, ISSN: 0891-5849, [retrieved on 19930301], DOI: 10.1016/0891-5849(93)90030-X

## Description

### FIELD OF THE INVENTION

The invention relates to a method for the *in vivo* studies of animal models with continuous wave (CW) X-band EPR spectroscopy. The present invention is also directed to a flat cell capillary for *in vivo* EPR measurements, as well as a system comprising such capillary. Disclosed herein is also an animal model that might be very useful to study *in vivo* development of different diseases including, as for example, melanoma or cholesterolemia and other related conditions and diseases, especially those which are characterized by the levels of predictive marker(s) with unpaired electrons.

### BACKGROUND OF THE INVENTION

Electron paramagnetic resonance (EPR) or electron spin resonance (ESR) spectroscopy is a method for studying different materials with unpaired electrons. The basic concepts of EPR are analogous to those of nuclear magnetic resonance (NMR), but in case of EPR it is electron spins that are excited instead of the spins of atomic nuclei which excitation is measured during NMR studies. EPR spectroscopy is particularly useful for studying metal complexes or organic radicals. The most widely used version of EPR spectroscopy is X-band EPR, with the resonance microwave frequency of 9.3-9.8 GHz.

Moreover, EPR spectroscopy is the only technique that provides direct information about free radicals in biological systems. The identification and quantification of free radicals is the most frequently performed in studies of oxidative stress, i.e. the overproduction of reactive oxygen and nitrogen species, including the free radical ones. However, due to the X-band EPR resonator dimensions, application of X-band EPR to *in vivo* studies is limited, and usually the *ex vivo* studies using tissues and their homogenates are performed. Furthermore, X-band EPR studies of biological samples often require sophisticated sample preparation protocols that could potentially affect oxidative stress effects in biological samples.

Model organisms are widely used to research human disease when studies performed directly on the human body would be unfeasible or unethical. This strategy is made possible by the common descent of all living organisms, and the conservation of metabolic and developmental pathways and genetic material over the course of the evolution. In researching human diseases, model organisms allow for better understanding of the disease process without the added risk of harming a human. The species chosen should usually meet a determined taxonomic equivalency to humans, so as to react to disease or its treatment in a way that resembles human physiology as needed. Although biological activity in a model organism does not ensure an effect in humans, many medicines, treatments and therapies for human diseases are developed in part with the guidance of animal models.

One of the problems in animal research is that higher vertebrates animal models are expensive (for example rat, mice) and widely recognized as unethical. Therefore, simpler models using invertebrates and lower vertebrates are more often widely used in the studies of human diseases.

The other application of model organisms are environmental studies, mainly the laboratory assessment of environmental (ecological) risk of use of chemical compounds, especially pollutants, which can be extrapolated to natural populations.

Examples of useful in such studies organisms include many model organisms considered to be helpful to understand particular biological phenomena, with the reasonable expectation that discoveries made in the model organism will provide insight into the workings of other organisms, among which following might be mentioned as particularly useful:

| Model organism | Size | Application |
|---|---|---|
| zebrafish (*Danio rerio*) embryos 1-5 dpf (days post fertilization) | egg diameter: 0.7 mm, embryos length is from 0.9 mm (20hpf) to 3.9 mm (dav 5) | human disease, ecotoxicology |
| daphnia | 0.2-5 mm | ecotoxicology and environmental genomics |
| aquatic snail (*Lymnaea stagnalis*) embryos | egg 1 mm, juveniles length: 2-3 mm | ecotoxicology of freshwater systems |
| copepod (*Tigriopus*) | 240 µm to 1 mm | ecotoxicology and environmental genomics |
| brine shrimp (*Artemia salina*) embryos | eggs hatch into nauplii that are about 0.5 mm in length, 4 mm at day 8 | ecotoxicology, cytotoxicity |
| three-spined stickleback (*Gasterosteus aculeatus*) embryos | egg diameter: 1.61 mm | environmental toxicology |

Unlike other animal models, such as higher vertebrates including rats or mice, the zebrafish embryos (*Danio rerio*) model does not raise ethical controversies regarding its use, is easy to maintain, has high correlation of the results with higher vertebrates. Moreover, the zebrafish embryo model is one of leading models used to study developmental biology, toxicology, and molecular genetics. In addition, the zebrafish is increasingly used to generate models of human diseases, especially including those in which oxidative stress is an important factor.

Zebrafish embryos toxicity tests are usually performed under the OECD guidelines for the testing of chemicals, Fish Embryo Acute Toxicity (FET) Test no 236. In practice, this test is subjected to some modifications. Describing in brief, eggs from naturally spawned fish (minimum 4 single pairs) are mixed, washed with E3 solution (standard *D. rerio* spawn incubation medium), randomly selected and placed in plates. Fish and eggs are maintained at 28°C with 14h light/10h darkness cycles. Usually, eggs are exposed to treatment from 4 hours post fertilization (hpf) and the experiment lasts up to 120 hpf. Mortality, hatching rate, and growth abnormalities are scored daily and compared with reference.

Often, zebrafish embryos toxicity studies are accompanied by *Daphnia magna* model organism. *Daphnia magna* model is recommended for ecotoxicological tests for chemicals (OECD, 2004.) as well as it is widely used in studies of mechanisms of toxicity, including oxidative stress mechanism.

Furthermore, also *Daphnia magna* studies are performed under the OECD guidelines, OECD Test Guidelines for Testing of Chemicals no 211, and as in case of zebrafish embryos, also this studies are sometimes subjected to minor modifications. According to protocol, "young female *Daphnia* (the parent animals), aged less than 24 hours at the start of the test, are exposed to the test substance added to water at a range of concentrations. The test duration is 21 days. At the end of the test, the total number of living offspring produced per parent animal alive at the end of the test is assessed".

This described briefly above model organisms can be used to carry out many different measurements, among others melanin radicals or membrane fluidity studies.

Melanin radicals studies are associated with studies of mechanism of UV-induced skin photocarcinogenesis, (Photoprotective properties of skin melanin, J-P. Ortonne, BJD 2002, vol. 146, issue s61), as well as new treatments of melanoma. Melanoma is the most aggressive skin tumour type, so there is a need to provide a tool to measure the melanin radical content in pigmented and non-pigmented animal models *in vivo* by using electron paramagnetic resonance (EPR) spectroscopy.

A number of melanoma studies with the use of EPR technique was performed (see Towards *in vivo* melanin radicals detection in melanomas by electron paramagnetic resonance (EPR) spectroscopy: a proof-of-concept study, 2019). Among them are EPR *in vivo* melanoma studies, which by determination of mechanisms associated with the conditions related to increased level of melanin radicals might be useful in monitoring of diseases development and evaluation of effectiveness of new treatment methods. Also, EPR technique is cheaper than NMR, which can also be used for *in vitro* imaging of melanoma in cell studies. EPR has previously been used in *in vivo* studies on rodents, wherein in such studies usually the 1 GHz EPR frequency is used. Approach of the present invention allows to use even cheaper and easier to handle standard benchtop X-band EPR spectrometer for such type of studies of melanoma. Moreover, the method for the *in vivo* studies of animal model and capillary of the present invention increase the sensitivity of experiments by allowing to use higher frequency (9.3-9.8 GHz instead of about 1 GHz) that may make it possible to register small changes of analyte, such as melanin radicals, concentrations and to obtain more detailed results. The use of zebrafish embryos instead of rats decreases significantly costs and time of initial experiments. Also, zebrafish could be easily genetically modified for conducting specific and more detailed research of disease development. Moreover, such model is not subject to controversy, and in the case of wild type zebrafish embryo model, extends the group of potential users since it does not require any specific qualification and/or permissions.

Membrane fluidity and thus membrane permeability changes are associated with many types of cancer, as well as other diseases, such as Alzheimer's disease, Parkinson disease etc. Moreover, membrane fluidity also plays role in permeability of specific drugs to the target tissues. Thus, membrane fluidity studies play a key role in exploration of mechanisms of a number of diseases, including cancer, as well as in screening biological activity of new compounds, which could be potential drugs. Applying *in vivo* model to study membrane fluidity is especially important as preliminary steps before clinical trials. Membrane fluidity, which is also correlated with membrane permeability, studies are usually carried on model membranes or isolated cell membranes. Thus, creating *in vivo* model for membrane fluidity is important for studying mechanism of a number of diseases, as well as testing new drug delivery systems. The use of zebrafish embryos allow relatively easy and fast specific genetic modifications for a required disease model (for example, blocking production of cholesterol, etc). Thus, analysis of EPR spectra of spin labels (compounds with paramagnetic properties, used as molecular probes in EPR studies) incorporated into membrane are crucial in studies with cholesterol levels or drug delivery studies.

Detecting melanoma by electron paramagnetic resonance is known in the prior art, i.e. it is disclosed in patent document no. AU2005249510A1. However, this document relates to a method using electron paramagnetic resonance spectroscopy to provide a signal from melanin to image a melanoma, to detect metastatic melanoma in a sentinel lymph node, to measure light penetration in melanocytes in skin, or to provide combinations thereof.

Moreover, in publication "Electron Paramagnetic Resonance Studies of Membrane Fluidity in Ozone-Treated Erythrocytes and Liposomes" (Biochem. Mol. Biol. Int. 1999 Jan;47(1), 99-105) Wrobel and Gomulkiewicz describe analysis of EPR spectra of spin labels incorporated into lipid bilayer of the erythrocyte membranes that indicates an increase in the mobility and decrease in the order of membrane lipids. However, this publication refers to the research carried out on blood cells and not on living model organisms such as Zebrafish.

Currently, on the market many apparatuses and equipment to carry out EPR measurements are available. For example, quartz capillaries for EPR are commercially available. Nevertheless, none of the known capillaries seems to be useful as equipment to study animal models, since the spatial structure of available capillaries makes it impossible to carry out any *in vivo* research, even on small animal models, such as zebrafish, Nematodes, daphnia, and other organisms living in an aquatic environment.

Moreover, when a sample contains water, it is very difficult to tune the spectrometer, i.e. to find frequency that is exactly the frequency of resonance for a given sample in resonator used, which means that no microwaves will be reflected back, but will remain inside the resonator. Further, the term "tuning" or "tuning of the spectrometer" as used in the present description ought to be understood as the establishing of resonance frequency.

The difficulty of tuning spectrometer when studying aqueous samples is due to the interaction of electric dipole moment of the water molecule with the electric field in the resonator, which results in a large amount of microwave energy absorbed by the sample. It leads to the high, non-resonant absorption of microwaves in the X-band frequency range by aqueous samples which results in the instability of the system caused by the heating of the sample, which in turn causes a tuning problem and makes impossible to conduct *in vivo* studies as living organisms have a high water content. Flat cells, X Band Aqueous Cells, confine the sample to a 0.3 mm wide space to solve this issue (see offer from Wilmad LabGlass sp scienceware). The sample volume of such cells is 150 µl for cell. However, these types of capillaries are not suitable for conducting *in vivo* experiments because of a too small size, and an additional disadvantage is that they are very expensive. Zebrafish embryos and other small model organism do not fit the 0.3mm inner width of the known capillaries.

Therefore, there is a great need to provide a capillary, whose production process is less expensive, and most of all a capillary that enables the *in vivo* testing of live organisms with X-band EPR.

On the other hand, it has to be mentioned that currently *in vivo* EPR studies are performed on lower frequencies (1.2-1.4 GHz). This enables deeper penetration of radiation and much lower heating effect for samples with a high water content, but results in a much smaller, even 100-10000 smaller, sensitivity. Thus, as far as now, it is not possible to study a small aquatic model organisms with the lower frequency EPR spectroscopy.

The present invention solves the above-mentioned issues. It allows testing of aquatic organisms with specified parameters, i.e. with at least two of three dimensions not larger than 0.4 mm, however having the third dimension, i.e. the length, up to 10 mm, since this is a limit of the resonator size.

One of the conditions enabling the measurement to be carried out is the packing of the tested object in such a way, that the said object, for example zebrafish embryos, have to constitute at least 60% of the total volume of capillaries to ensure sufficient amount of biological material and thus sufficient amount of paramagnetic substances, which on one hand gives an EPR signal and on the other lowers the water content. This enables the tuning of the spectrometer and minimizes the non-resonant losses of microwave radiation, at the same time ensuring the survival of model organisms in the capillary. The survival rate decreases when the packing of model organisms is too dense. Whereas only about 15-20 fish are used in the standard capillary, from 20 to 60 fish might be packed into the capillary according to the present invention. Usually, present inventors found to be most useful to use 30-40 fish to ensure the signal of best quality and the highest fish survival rate.

Capillaries for EPR measurements, especially flat cell capillaries, are dislcosed in the catalogue "Lab Glass Wilmad: EPR Consumable and Accessories", 2011. The article Veeramani S. et al., "Shell-bound iron dependant nitric oxide synthesis in encysted Artemia parthenogenetica embryos during hydrogen peroxide exposure", Biometals, vol. 24, no. 6, 2011, pp. 1035-1044, describes in vivo EPR studies on cyst samples in flat cell EPR tubes.

### SUMMARY OF THE INVENTION

In the first aspect of the invention a method of conducting an *in vivo* EPR measurement is provided, which comprises the following steps:
a) inserting a live aquatic model organism in a sample solution into a flat cell capillary, so that the model organism is immobilized in the flat part of the flat cell capillary;
b) inserting the filled capillary from step (a) into an EPR spectrometer, so that during an *in vivo* EPR measurement a signal from the flat part of the flat cell capillary is registered;
c) performing an *in vivo* EPR measurement and detecting the signal from the model organism immobilized in the flat part of the flat cell capillary, wherein the EPR measurement is carried out at room temperature.

The flat cell capillary that is used in the method of the invention is in a form of an elongated cylindrical tube having one inlet part and one outlet part, wherein between the inlet and outlet parts of the tube there is a flattened part, which forms a sample holder cell. The size of the tube and the sample holder cell of the flat cell capillary used in the method of the invention ensures vitality of the model organism during the step of inserting the model organism into the capillary, during the EPR measurement and after the measurement is completed. The flat cell capillary is a capillary made in a continuous manner, i.e. it does not contain any discontinuities in its material nor parts which can be repeatedly detached and reattached. The flat cell capillary used in the method of the invention has very specific dimensions: the inlet and outlet parts of the cylindrical tube have an internal diameter of 4 to 5 mm, the sample holder cell has a length ranging from 10 to 30 mm and thickness of 0.4 to 0.8 mm. Moreover, in a preferred embodiment the sample holder cell of the flat cell capillary has a volume in the range 60 to 100 µL, preferably 70 to 90 µL, and more preferably amounts to about 80 µL.

Also preferably, the above identified step (a) of the method of the invention comprises the following sub-steps:
aa) placing the sample solution into the flat cell capillary;
ab) sealing the outlet part of the flat cell capillary;
ac) placing the model organism just above the sample solution, in the inlet part of the flat cell capillary;
ad) moving the model organism into the sample holder of the flat cell capillary by slow rotation or shaking; and
ae) removing of redundant sample solution.

In preferred embodiments, in order to perform an *in vivo* EPR measurement, it is necessary to include a spin probe inside the model organism. Therefore, the method of the invention preferably further comprises an additional step of incubation of the model organism with a spin probe solution prior to the *in vivo* EPR measurement. In the most preferred embodiments the model organism is incubated with a spin probe before it is inserted into the flat cell capillary, and the model organism is thoroughly rinsed before it is placed in the flat cell capillary, so that any signal registered from the spin probe comes from the model organism, and not from the sample solution, in which the model organism is inserted.

Many aquatic small size organisms can be used in the method of the invention. In the preferred embodiment, the method of the invention employs a model organism which is selected from a group comprising *Danio rerio, Daphnia, Lymnaea stagnalis, Tigriopus, Artemia salina and Gasterosteus aculeatus.* More preferably, *Danio rerio* is used as the model organism in the method of the invention.

The method of the invention can find a number of uses. In particular it can be used to determine a number of biological and/or physical parameters of the model organism. Therefore, the invention also provides a use of the method of the invention for determining of biological and/or physical parameters of the model organism. Preferably, the method of the invention can be used to determine melanin radical level, membrane fluidity and short-living free radicals level. The method is particularly useful in determining changes in these biological and/or physical parameters, as a result of a change of conditions to which the model organism is exposed.

Another subject of the invention is a flat cell capillary for *in vivo* EPR measurements. The flat cell capillary according to the invention, as described above, is in a form of an elongated cylindrical tube having one inlet part and one outlet part, wherein between the inlet and outlet parts of the tube there is a flattened part, which forms a sample holder cell. The inlet and outlet parts of the tube have an internal diameter between 4 and 5 mm. The sample holder cell has a length of between 10 and 30 mm, preferably between 15 and 25 mm, and more preferably it is equal to 20 mm. Finally, the thickness of the sample holder cell is between 0.4 and 0.8 mm, preferably between 0.5 to 0.7 mm, and more preferably it is equal to 0.6 mm. The capillary is made in a continuous manner, i.e. it does not contain any discontinuities in its material nor parts which can be repeatedly detached and reattached.

The volume of the sample holder is another important parameter of the flat cell capillary of the invention. The volume of the sample holder cell ranges from 60 to 100 µL, preferably from 70 to 90 µL, and more preferably it is equal to 80 µL.

Also in the preferred embodiment the length of the inlet and outlet parts of the flat cell capillary according to the invention amounts to at least 125 mm and 5 mm, respectively.

The flat cell capillary according to the invention is made of glass or quartz. It should be emphasized that the entire capillary is made in a continuous manner, i.e. it does not contain any discontinuities in the material nor parts which can be repeatably detached and reattached.

Finally, the invention provides a system for *in vivo* EPR measurements comprising a flat cell capillary according to the invention and a model organism introduced into that flat cell capillary. Preferably the model organism in the system of the invention is selected from a group comprising *Danio rerio, Daphnia, Lymnaea stagnalis, Tigriopus, Artemia salina and Gasterosteus aculeatus.*

### BRIEF DESCRIPTION OF THE DRAWINGS

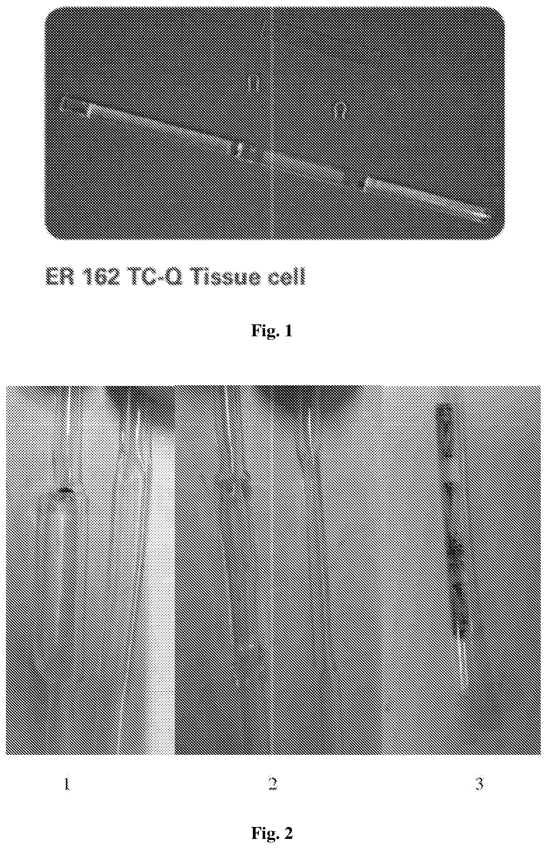

**FIG. 1** presents tissue cell capillary, commercially offered by Bruker. Its outer dimensions are as follows: 50 mm long, 2 mm thick and 10 mm wide. The dimension of the tissue cavity is 23 mm x 7 mm x 0.5 mm.
**FIG. 2** presents flat cell capillaries of the present invention, quartz (1) and glass (2) and standard 100 µL haematocrit capillary (3) with fish.

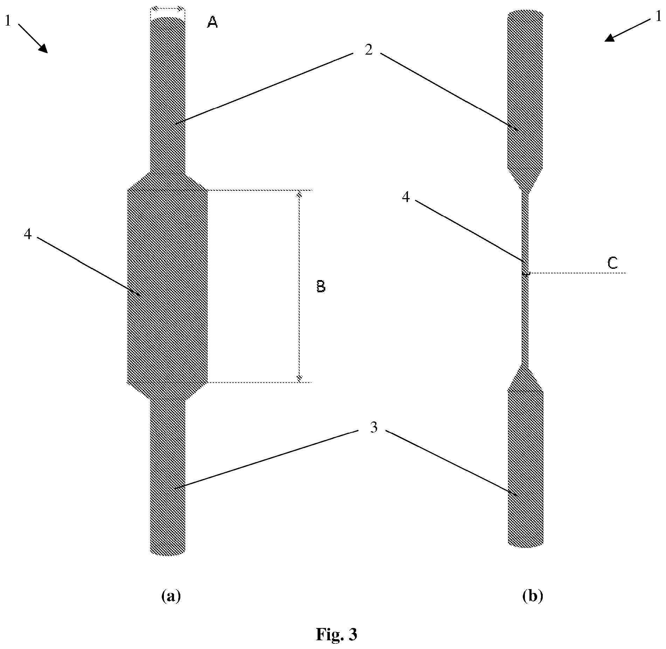

**FIG. 3** presents a schematic drawing of a flat cell capillary according to the present invention - (a) a front view and (b) a side view. Its dimensions are as follows: A - from 4 to 5 mm diameter, B - from 20 to 30 mm, C- from 0.4 to 0.8 mm.

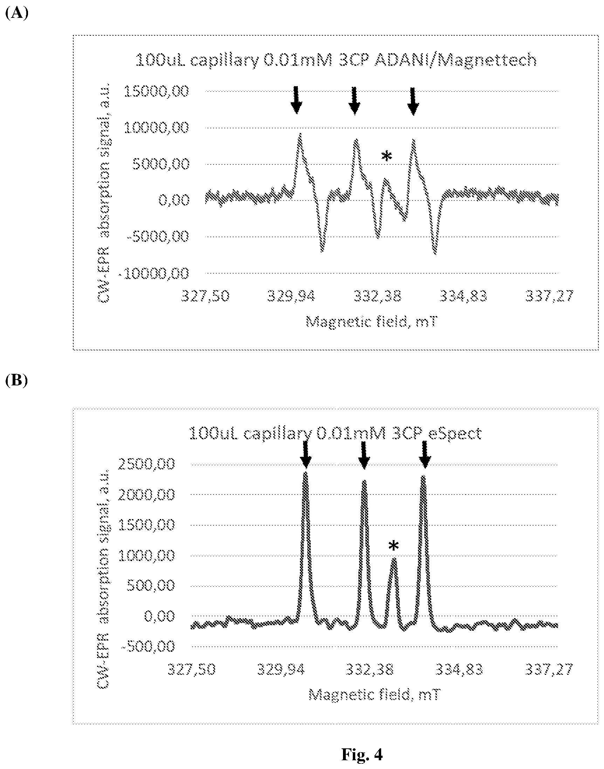

**FIG. 4** presents CW-EPR signal from 0.01 mM 3-carbamoyl-PROXYL reference solution (triplet, arrows) in standard 100 µL capillary. Impurities in glass give additional signal (singlet, * marker), direct signal from benchtop X-band spectrometer Magnettech/Adani (A), Signal processed with eSpect+ by Novilet (multiharmonic analyzer) (B).

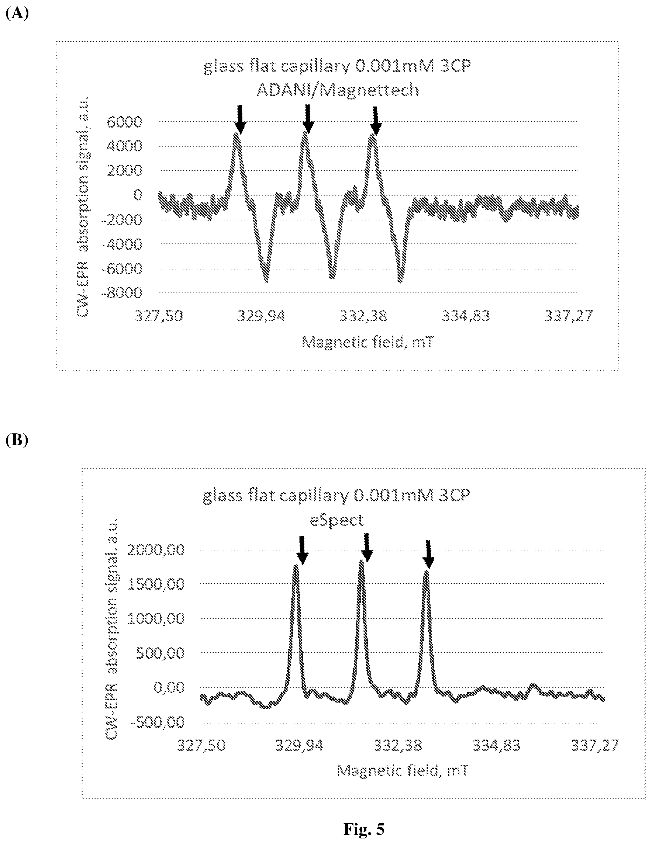

**FIG. 5** presents CW-EPR signal from 0.001 mM 3- carbamoyl-PROXYL reference solution (triplet, arrows) in our glass flat capillary. There is no additional signal from impurities in glass. Direct signal from benchtop X-band spectrometer Magnettech/Adani (A), signal processed with eSpect+ accessory by Novilet (multiharmonic analyzer) (B).

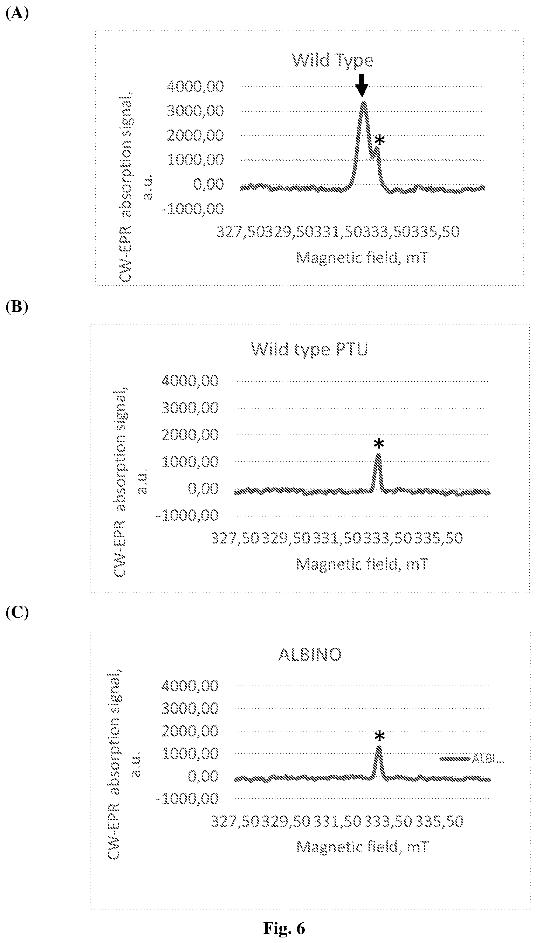

**FIG. 6** presents wild type zebrafish embryos melanin radical signal (A) vs wild type with PTU (B) vs Albino (C). CW X-band EPR signal in 3 days post fertilization zebrafish embryos from melanin radicals (marked with arrow) and from glass impurities (marked with *) in standard 100 µL capillaries wild type (ABxTL), wild type treated with 50 µM PTU solution and Albino. Addition of PTU prevents formation of melanin pigmentation in zebrafish embryos. Albino zebrafish does not develop melanin pigmentation.

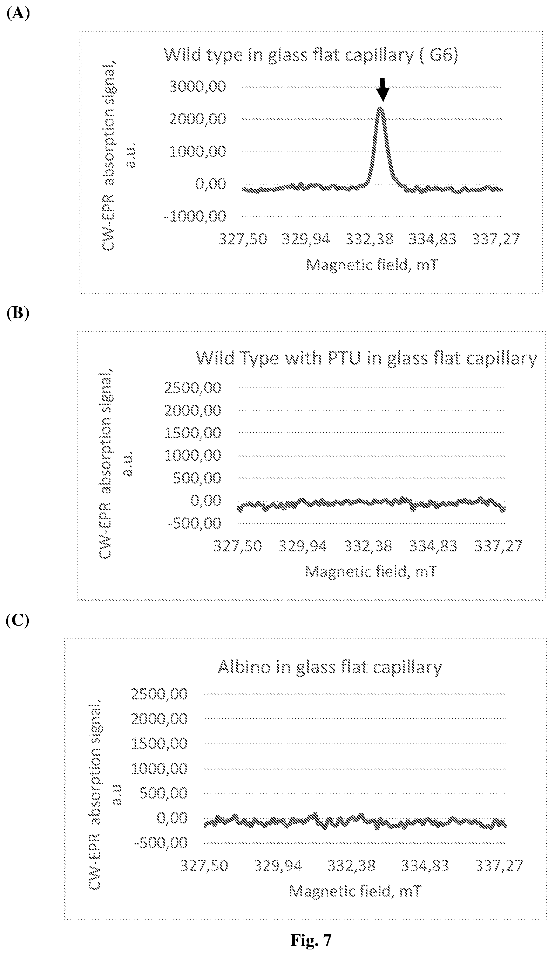

**FIG. 7** presents CW X-band EPR signal from melanin radical in 3 days post fertilization zebrafish embryos in glass flat capillaries made from 4 mm tubes, wild type (ABxTL) (A), wild type with 50uM PTU (B) and Albino (C). Addition of PTU prevents formation of melanin pigmentation in zebrafish embryos. Albino zebrafish does not develop melanin pigmentation.

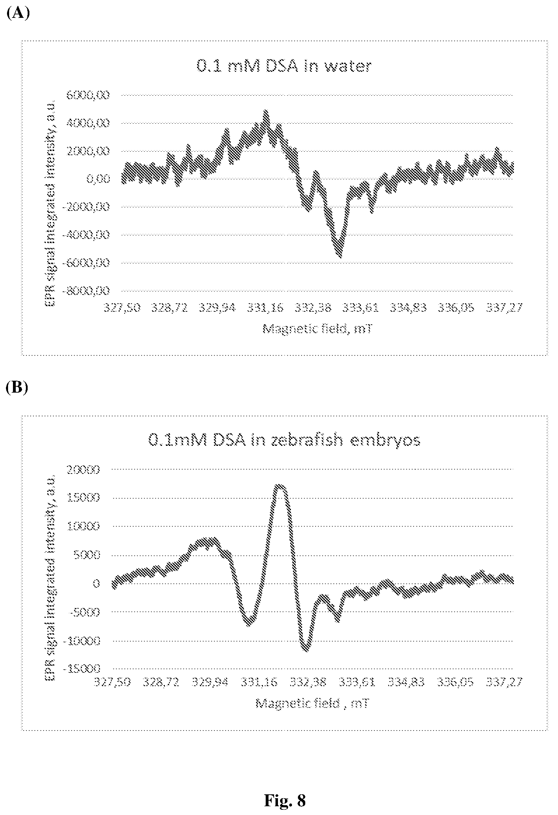

**FIG. 8** presents DSA (5-doxyl stearic acid) incorporation into fish membrane. (A) CW X-band EPR signal from 0.1 mM DSA in egg water, the medium in which fish were kept. Triplet signal is from free DSA spin probe which is not incorporated in any membrane, and thus could rotate freely thus giving an isotropic signal. (B) X-band EPR signal from 0.1 mM DSA incorporated into fish membranes, clearly signal is broadened and is not isotropic.

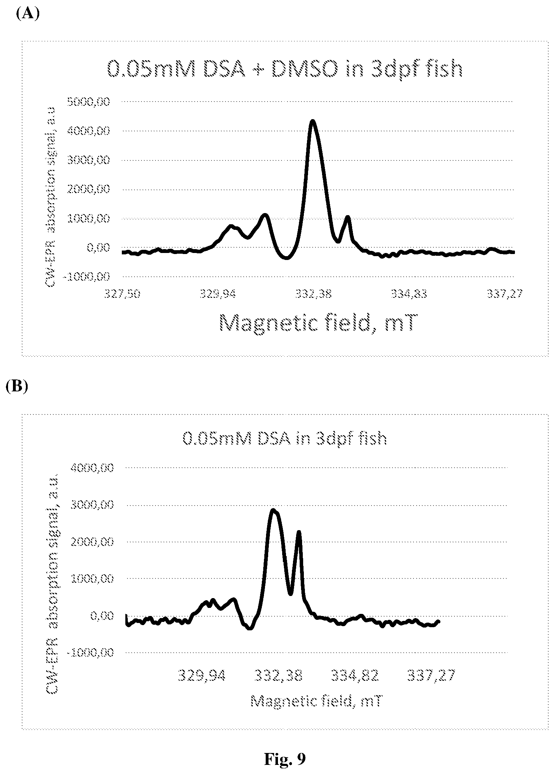

**FIG. 9** presents effect of DMSO on DSA incorporation. CW X-band EPR signal from 0.05 mM DSA (A) from DSA incorporated into fish membranes in the presence of DMSO which modifies the fluidity of the membrane reference system, (B) without DMSO, reference signal from DSA incorporated into fish membranes

### DETAILED DESCRIPTION OF THE INVENTION

A number of studies were conducted to show both simulations and experiments on the relation of signal quality to the sample parameters, capillary geometry and resonator shape. For example, the publication "Aqueous sample in an EPR cavity: sensitivity considerations" relates to TE011 resonator, which is a spherical EPR cavity, however it is neither widely used nor widely available. In that case, indeed water samples in 0.5-0.66 mm Teflon or quartz tubes are fine for getting a good EPR signal. A theoretical publication concerning the measurements of aqueous samples by X-band EPR in flat cells ("Aqueous flat cells perpendicular to the electric field for use in electron paramagnetic resonance spectroscopy" by Sidabras, Mett and Hyde, Journal of Magnetic Resonance 172 (2), 2005. 333-341) with standard rectangular resonator (TE102 cavity, the one benchtop EPR spectrometers have) and flat cells shows some decrease in signal at the 0.5 mm size. This dimension is not optimal one for the flat cell, therefore 0.2-0.3 mm is typically used.

Moreover, data presented above are for standard size EPR spectrometer, which provide much more homogenous magnetic field and thus easier tuning than benchtops. So the surprising effect is mainly for benchtop X bands spectrometers. However, standard EPR spectrometers are much more complicated in use than benchtops, and thus need to be operated by a skilled spectroscopist, while benchtop EPR spectrometers can be used by a biologist working with animal models listed above.

The flat capillary of the present invention has a rather large volume (the inner thickness of the capillary (i.e. the distance between the walls of the flattened part of the capillary) amounts to 0.5-0.7 mm for an aqueous sample in the standard rectangular resonator cavity of benchtop spectrometers. It should be emphasized that usually no experiments are performed under such conditions because benchtop spectrometers do not tune or the tuning is very difficult in such conditions.

Thus, commercially available capillaries for conducting measurements of aqueous samples are quartz tubes of the length of 15-20 cm with a flattened part with the internal thickness, i.e. the smallest dimension, in the range of 0.1-0.4 mm, the width of 5-7 mm and the height of 20-30 mm to guarantee that the tuning of the spectrometer is possible. Larger capillaries with 0.5 mm internal thickness of the flattened part, i.e. larger than thickness of commercially available capillaries intended for aqueous samples, are used for tissue measurements (highly viscous samples). However, they consist of 2 separate parts, so would not hold water needed for zebrafish or other aquatic model animals to survive, and do not allow access of air to the samples (see Fig. 1).

Capillaries made of glass are suitable for carrying out the experiments described in the present description. Usually, capillaries useful to conduct EPR measurements known in the art are made of quartz, which makes them very expensive. Quartz remains preferred material used to avoid undesirable signals from glass (namely, from paramagnetic impurities in glass). Moreover, glass is not used in widely known flat capillaries as it is known that glass contains paramagnetic impurities that could give rise to a signal overlapping the signal from the sample. Surprisingly, in the present invention, it was observed that it is possible to use glass capillaries to carry out *in vivo* research, especially using model organisms living in an aquatic environment, in particular zebrafish. Other model organism, such as Nematodes, daphnia and others, can also be used as model organism without observing overlapping of signals from model organisms and the glass capillary. Particularly, no interfering signal impurities were registered, although the capillaries of present invention are not made from any specific, selected glass. Most probably, in the case of the capillaries according to present invention the glass gives a very broad signal (the baseline), which is neglectable (not visible) in EPR spectra in comparison to the signal registered for aquatic animal model.

The present invention relates to both glass and quartz flat cell capillaries, which comprise a sample holder in a form of a flattened part, whose dimensions allow *in vivo* measurements on animal model using the EPR method.

The flat cell capillary 1 of the present invention is presented schematically on Fig. 3. The flat cell capillary of the invention is in a form of an elongated cylindrical tube having one inlet part 2 and one outlet part 3, wherein between the inlet and outlet parts 2,3 of the tube there is a flattened part 4, which forms a sample holder cell. In the present description terms "a flattened part", "a flat part" and "a sample holder" are used interchangeably and are denoted by numerical reference 4. The optimal diameter A of the tube, corresponding to the diameter of the inlet and outlet parts of the tube, in cases of both glass and quartz capillaries, is from 4 to 5 mm. The diameter mentioned above, is the internal diameter of the inlet and outlet parts of the tube. It has to be emphasized that diameter between 6 - 7 mm renders tuning of the spectrometer using a reference compound impossible. Moreover, a capillary having a larger diameter will not fit the resonator of the EPR spectrometer. The cross-section of the inlet part 2 of the flat cell capillary 1 has to be circular or nearly circular, while the outlet part 3 of the flat cell capillary 1 can have a cross-section of any shape. Therefore, the cross section of the inlet part 2 of the flat cell capillary is elliptical, preferably circular. In the preferred embodiment, the outlet part 3 of the flat cell capillary 1 has the same cross section as the inlet part 2 of the flat cell capillary 1. The cross-section of the inlet and outlet parts 2,3 should be understood as a cross-section perpendicular to the axis of the elongated cylindrical tube, which forms the flat cell capillary.

The flattened part 4 of the flat cell capillary 1, which forms the sample holder cell where the model organisms are inserted for the EPR measurement, is located between the inlet and outlet parts 2,3 of the flat cell capillary 1. The dimensions of the flat part of the capillary are selected in such a manner so that they unexpectedly allow to carry out *in vivo* measurements using the model organisms. The model organisms inserted into the capillary remain vital throughout and after the EPR measurement.

In preferred embodiment both cross-sections of the flattened part 4 - perpendicular and parallel to the axis of the elongated cylindrical tube, which forms the flat cell capillary - are essentially rectangular. The length B of the flattened part, i.e. the dimension of the flattened part 4, measured parallelly to the axis of the elongated cylindrical tube, varies from 10 to 30 mm. The optimal length is from 15 to 25 mm. That is also the most suitable size for measurements carried out with zebrafish embryos model. In case of zebrafish, larger lengths of the flattened part 4 would render the EPR measurement impossible, allowing the fish to swim out of the resonator, whereas smaller length would not allow to put a sufficient number of fish into the sample holder. The thickness C of the flat part of the flat cell capillary of the invention, i.e. the dimension of the flattened part 4 measured perpendicularly to the axis of the elongated cylindrical tube, varies in the range from 0.4 to 0.8 mm. Considering the above discussed internal dimensions of the flattened part 4 of the flat cell capillary, the volume thereof is in the range 60 to 100 µL, preferably 70 to 90 µL, and most preferably is around 80 µL. The volumes higher than 120 µL (i.e. thickness of 1.5-2 mm) render the obtaining of the EPR signal impossible.

The length of the entire flat cell capillary depends on the size of the resonator. The inlet part length is at least 125 mm so it would be possible to mount it in the holder of EPR spectrometer while the outlet part length is at least 5 mm.

### EXAMPLES

### D. rerio embryos

Embryos are collected 4 hours after fertilization and transferred to Petri dishes. They are incubated in E3 solution or in the test substance solution at 28°C in a day/night cycle until measurement, up to 5 days after fertilization. It is worth emphasizing that such embryos do not require the consent of the ethics committee to use them for research. The incubation medium is changed daily. At the latest on the 5th day after fertilization, all embryos are euthanized by first applying a concentrated solution of the anesthetic (tricaine), followed by prolonged cooling.

### EPR measurements

All EPR measurements are performed on an EPR spectrometer operating in the X band, e.g. MiniScope200, MS200, Magnettech, equipped with a standard rectangular resonance cavity, e.g. TE102, at room temperature. However they are easily reproducible on other benchtop spectrometers as well as standard size X band and potentially Q band spectrometers, as they all use the same shape of resonator.

Measurement parameters include:
- attenuation 25-30 dB,
- measuring time up to 6 minutes,
- tuning time maximum 1-2 minutes,
- modulation amplitude of at least 0.1 mT due to the fact that with lower amplitude readings could not be performed, and additionally the Novilet attachment requires modulation amplitude of 0.5 mT ,
- total embryo residence time in the capillary: up to 1 hour.

Prior to EPR measurement, *D. rerio* embryos are introduced into the capillary. For embryos 24 to 48 hours after fertilization, the egg covers, chorions, are removed prior to measurement. The chorions are removed mechanically or with the use of special enzymes. At least 20 embryos must be obtained for a measurement.

First, 80 µL of sample solution/E3 solution is placed with the pipette into the capillary. The sample is positioned exactly in the flat part by gravitation (balancing). Outlet of the capillary is sealed with sealing material, such as a wax sealant (for example sealing wax commercially available from Globe Scientific) or with plastic tap. Then, zebrafish embryos are transferred one by one with the aid of 100 µL capillary via the inlet part of flat cell capillary, in the vertical position. The embryos are placed just above the sample solution, in non-flat part of capillary. When desired number of embryos is transferred into flat capillary, the slow rotation and shaking of the capillary allows to move embryos into the flat part. Then, the redundant solution, which is outside the flat part of the capillary, is removed with the aid of 100 µL haematocrit capillary.

In practice, due to the construction of known commercially available resonators, detecting of signal is conducted in vertically oriented capillary.

### EXAMPLE 1

### Sensitivity of the EPR measurements conducted at operating frequency around 1GHz which is standard in in vivo studies

The experiments with the L-band EPR tomograph at Novilet with operating frequency around 1GHz (for comparison, X band EPR operates at about 9.5 GHz) have been performed. It is suitable for low frequency *in vivo* studies of small animals, like rats. This experiment was performed in order to check whether it was possible to obtain a L-band EPR spectrum of zebrafish embryos *in vivo.* In this studies 200 embryos in one tube per one measurements were used. Based on the studies it can been determined that no radical signal is obtained within such frequency.

### EXAMPLE 2

### Comparison of flat cell, flat capillary, standard tube and standard capillary

The table below compares the geometry, price and applicability of the commercially available tubes/capillaries with the flat capillary of the present invention.

Specific geometry, despite larger inner thickness, still allows tuning of the spectrometer and obtaining signal for zebrafish embryos *in vivo* model. The material for the flat cell capillaries according to the invention could be glass, which makes the capillaries of the invention less expensive. The production method is extremely easy and cheap. The flat capillary of the present invention could be easily produced from commercially available quartz and glass tubes, thus no special production requirement has to be applied.

| | **Commercial flat cell** | **Glass/quartz tubes** | **Glass capillaries, 100 µL** | **Flat capillary of the present invention** |
|---|---|---|---|---|
| **Inner thickness/sample volume** | 0.1 mm to 0.2 mm, 50 µL | | to insert, 2mm | 0.5-1.5 mm, 60-120 µL (80-100 µL optimal) |
| **Fish fits** | no | Yes | yes, usually, curved | yes, could swim |
| **Fish alive** | no | Yes | limited to 5-10 minutes | yes, several experiments, several days subsequent measurements |
| **Number of fish** | n/a | 20 | 10 | 20-30 |
| **Tuning of spectrometer with fish*** | n/a | No | yes | yes |
| **Price** | 10000-13000 PLN | 400 PLN | 500 PLN/1000 pieces | 60 PLN netto per glass and 120 PLN netto per quartz |

| | | | | |
|---|---|---|---|---|
| * tuning of spectrometer is crucial for the measurements. | | | | |

### EXAMPLE 3

### Comparison studies of EPR measurement sensitivity

In the comparison studies of EPR measurement sensitivity, 3-carbamoyl-PROXYL at 0.01 mM concentration was used as a control. The measurements were conducted with benchtop X-band EPR, at room temperature. This is standard detection limit in benchtop X-band spectrometers. Benchtop parameters: power attenuation 25dB, modulation amplitude 500 µT (for eSpect+ (EPR expansion module, Novilet) registration) and 100 µT for standard registration, scan time 11s, scan range 10 mT. The spectra as registered during measurements are shown in Fig. 4 and Fig. 5. Triplet signal is marked with arrows, whereas asterisk marks signal from glass capillary.

The detection limit with eSpect+ by Novilet is 0.001 mM concentration of spin agents.

The obtained results suggest that use of flat capillary according the present invention allows to get rid of impurity signal from glass. That makes further analysis easier. Use of eSpect+ accessory allows to increase the sensitivity level of the spectrometer. That is essential for *in vivo* studies, where very low signals usually are obtained, because the spin agents in high concentrations are toxic to living organisms, and also living organisms tend to metabolize spin agents fast.

### EXAMPLE 4

### Survival of zebrafish embryos in capillary (exposure/mortality test)

The aim of this experiment was to find the optimal EPR parameters for the *in vivo* studies of zebrafish embryos with EPR. The parameters are optimal when we can see EPR signal and all fish are alive at the end of the measurement so they could be used in subsequent day for the EPR measurements. The survival rate of the zebrafish embryos placed for EPR measurements in standard 100 µL capillary and our flat capillary was compared.

Standard measurements of survival rate were carried out by placing fish into 100 µL and into flat capillaries according the present invention. The process of embryos loading into capillary was described above. The capillary was placed into benchtop X-band Spectrometer (Magnettech/Adani, MS200). Usually, the embryos were kept inside the resonator (spectrometer) for 16 scans by 11s plus tuning time around 4 minutes. The table below shows the survival rate depending on the power, modulation amplitude and time of EPR measurement. All these parameters lead to heating of the sample, and thus overheating of the fish. Low power (i.e. high attenuation expressed in dB), short time and low modulation amplitude are preferable for the fish survival rate, however could be not sufficient to get EPR signal. 100% survival rate means that after EPR measurement, and release of fish into Petri dish, all fish were alive and able to swim and remained in such a condition till next day EPR measurement, while the 0% survival rate means that no fish were alive after EPR measurement.

| | | | | | | |
|---|---|---|---|---|---|---|
| dB | 35 | 35 | 35 | 25 | 25 | 20 |
| measurement times | 320 | 480 | 640 | 176 | 176 | 176 |
| modulation amplitude | 100µT | 100µT | 100µT | 500µT | 100µT | 500µT |
| 100uL tubes | 100 % | partly | 0% | na* | na | na |
| 4mm glass capillary | | | 100 % | 100 % | 100 % | 100 % |
| 4mm quartz capillary | | | 100 % | 100 % | 100 % | 100 % |

| | | | | | | |
|---|---|---|---|---|---|---|
| *na - not applicable due to resignation of conducting measurements in view of lack of survival of embryos during the measurements in milder conditions. | | | | | | |

When tuning time is reduced to 30 seconds, longer measurement time/ repetition of experiment/ and up to 20 dB could be applied.

The obtained results suggest that the use of flat capillary according the present invention guarantee the 100% survival rate for the fish with up to 640s of measurements at 35dB, and with 170s up to 20 dB (that is not possible with standard 100uL capillaries)

### EXAMPLE 5

### Melanin radical studies

The aim of the study was to show the detection of melanin radical in wild type zebrafish embryos with benchtop EPR spectrometer, and ways to affect it (signal from melanin radical).

Melanin radical studies were carried out using benchtop EPR X-band spectrometer (Magnettech/Adani, MS200) and presented flat EPR capillary in *Danio rerio* embryo model.

Normally, after 2 days post fertilization in wild type zebrafish embryos a melanin radical signal could be observed (Fig 6 and Fig 7, A) as pigmentation of fish is developed. On the other hand, albino fish do not develop melanin pigmentation (Fig 6, C, Fig. 7, B), and thus no melanin radical is observed. In wild type fish, the constant presence of PTU (Fig. 6, B) decreases the production of pigmentation, and thus melanin radical, whereas relanium addition increases the pigmentation, at the same time leading to short time decrease of melanin radical signal.

For measurements, 20 to 40 embryos are introduced into a flat capillary, which is placed in a spectrometer. Standard parameters are used for measurements.

An enlarged single line is observed, the intensity of which is related to the concentration of melanin radical - it does not appear in the case of *D. rerio* albino variety. The intensity of this signal can be modified by inhibiting or accelerating the synthesis of melanin pigments in D. *rerio* embryos using chemicals (e.g. relanium, hydroquinone, sesamol). After completion of the EPR measurements, *D. rerio* embryos are released into a Petri dish into buffer E3 until further measurements/microscopic observations are made.

Thus, melanin radical in zebrafish embryos could be observed with ERP technique *in vivo* without any additional spin probes or spin traps. The amount of melanin radical (and intensity of the EPR signal) could be modified by using albino zebrafish embryos or PTU solution on wild type zebrafish embryos. What is worth emphasizing, this is a new model for studies of melanin radical *in vivo,* which could be used in melanoma studies.

### EXAMPLE 6

### Membrane fluidity studies (EPR spectroscopy using spin probes)

The aim of the study was to show the detection of changes in membrane fluidity *in vivo* with benchtop EPR.

Membrane fluidity studies were carried out using benchtop EPR X-band spectrometer (Magnettech/Adani, MS200) and presented flat EPR capillary in *Danio rerio* embryo model.

1 to 24 hours before the measurement, *D. rerio* embryos are placed in the spin probe (DSA) solution. In addition, a membrane fluid modifying factor, DMSO, is added to the solution, however, also other well-known modifying factors such as different salts might be used.

Before measurements, the embryos are washed with E3 buffer at least five times to remove from the system a spin probe remaining in the solution. Then, the solution is tested for the presence of spin probes (EPR signal), and additional washing is carried out if necessary i.e. if the signal from spin probe is still present in the solution. If there is no signal that means that concentration of the spin probe in solution is below our detection limit (0.001mM) and any observed signal would originate from the embryos. Before measurement, the spectrometer is tuned to a 0.01 M solution of 3-carbamoyl-PROXYL in water, in a 50 µl hematocrit capillary. For measurement 20 to 40 embryos are placed in a flat capillary and introduced into a spectrometer. After completion of the EPR measurements, *D. rerio* embryos are released into a Petri dish into buffer E3 until further measurements and/or microscopic observations.

DSA signal confirms that spin probe is incorporated into fish membrane (Fig. 8). The addition of DMSO resulted in more fluid membrane and thus other type of DSA signal (Fig. 9). After simulation it is be possible to get some membrane fluidity parameters.

Thus, membrane fluidity in zebrafish embryos could be studied with EPR technique *in vivo* using DSA-type spin probes. The changes in fluidity are reflected in the shape of EPR spectra. What is worth emphasizing again, this is a new model for studies of membrane fluidity *in vivo.* It could be crucial in studies with cholesterol levels and drug delivery studies, i.e. what can make the drug to penetrate through membrane.

### EXAMPLE 7

### Oxidative stress in vivo studies in the zebrafish embryo model

In the present research, X-band EPR and multiharmonic analysis with eSPECT+ were combined to study the oxidative stress *in vivo* in the zebrafish embryo model. 4 hpf zebrafish embryos were incubated in the 1 mM - 10 mM solution of spin traps (DMPO [5,5-dimethylpyrroline-N-oxide], POBN [α-(4-pyridyl N-oxide)-N-tert-butylnitrone], and PBN [α-phenyl N-tert-butylnitrone]). A number of systems (Fenton, PAA/MnO₂, H₂O₂, CuCl₂) were used to induce oxidative stress in the zebrafish embryos.

In the case of CuCl₂ - induced oxidative stress, the DMPO spin trap gave an EPR singlet line. The Fenton reaction was relatively safe for zebrafish embryos, whereas PAA/MnO₂ (after several minutes of contact time) was toxic to zebrafish embryos. The optimal EPR spectrometer parameters, both safe for zebrafish embryos and sufficient to get EPR spectrum, were up to 16 scans by 11 s, 10 mT sweep, and 0.03 mW power. The maximum nontoxic concentrations of the spin agent were 10 mM, 5 mM, and 5 mM for DMPO, POBN, and PBN, respectively.

### EXAMPLE 8

### Membrane fluidity studies in the Artemia salina model

The studies of membrane fluidity could be performed also with the *Artemisia salina* model. The experiment is performed in a similar manner as described in Example 6. Eggs of *Artemia salina* hatch into nauplii that are about 0.5 mm in length. These freshly hatched nauplii are exposed to the spin probe solution together with a studied compound/extract solution which could modify the membrane fluidity. After an exposure (1-24h) nauplii are washed with a medium free of spin probe at least 5 times. Then, the solution is tested for the presence of spin probes (EPR signal), and additional washing is carried out if necessary i.e. if the signal from spin probe is still present in the solution. If there is no signal that means that concentration of the spin probe in solution is below our detection limit (0.001mM) and any observed signal would originate from the nauplii. Then from 20 to 50 nauplii are brought into the capillary and put into the spectrometer resonator. The EPR spectrum is recorded with similar to zebrafish embryos parameters. The membrane fluidity parameters could be extracted from the parameters of registered EPR spectrum of spin probe.

## Claims

1. A method of conducting an *in vivo* EPR measurement, comprising the following steps:
a) inserting a live aquatic model organism in a sample solution into a flat cell capillary, so that the model organism is immobilized in the flat part of the flat cell capillary;
b) inserting the filled capillary from step (a) into an EPR spectrometer, so that during an *in vivo* EPR measurement a signal from the flat part of the flat cell capillary is registered;
c) performing an *in vivo* EPR measurement and detecting the signal from the model organism immobilized in the flat part of the flat cell capillary,
wherein the EPR measurement is carried out at room temperature, and
wherein the flat cell capillary (1) is a capillary made in a continuous manner, i.e. it does not contain any discontinuities in its material nor parts which can be repeatedly detached and reattached, in a form of an elongated cylindrical tube, having one inlet part (2) and one outlet part (3), wherein between the inlet (2) and outlet (3) parts of the tube there is a flattened part (4), which forms a sample holder cell,
wherein the inlet (2) and outlet (3) parts of the tube have an internal diameter (A) from 4 to 5 mm, the sample holder cell (4) has a length (B) from 10 to 30 mm and thickness (C) from 0,4 to 0,8 mm.

2. The method of claim 1, wherein the size of the tube and the sample holder cell ensures vitality of the model organism during the step of inserting the model organism into the capillary, during the EPR measurement and after the measurement is completed.

3. The method of claim 1 or 2, wherein the volume of the sample holder cell is in the range 60 to 100 µL, preferably 70 to 90 µL, and more preferably amounts to about 80 µL.

4. The method according to any of claims 1 to 3, wherein step (a) comprises the following sub-steps:
aa) placing the sample solution into the flat cell capillary (1);
ab) sealing the outlet part (3) of the flat cell capillary (1);
ac) placing the model organism just above the sample solution, in the inlet part (2) of the flat cell capillary (1);
ad) moving the model organism into the sample holder (4) of the flat cell capillary (1) by slow rotation or shaking; and
ae) removing of redundant sample solution.

5. The method according to any of claims 1 to 4, wherein the method further comprises an additional step of incubation of the model organism with a spin probe solution prior to the *in vivo* EPR measurement.

6. The method according to any of claims 1 to 5, wherein the model organism is selected from a group comprising *Danio rerio, Daphnia, Lymnaea stagnalis, Tigriopus, Artemia salina and Gasterosteus aculeatus.*

7. Use of the method according to any of claims 1 to 6 for determining of biological and/or physical parameters of the model organism,
wherein the biological and/or physical parameters of the model organism include melanin radical level, membrane fluidity and short-living free radicals level.

8. A flat cell capillary for *in vivo* EPR measurements in a form of an elongated cylindrical tube having one inlet part and one outlet part, wherein between the inlet and outlet parts of the tube there is a flattened part, which forms a sample holder cell, **characterized in that** the inlet (2) and outlet (3) parts of the tube have an internal diameter (A) between 4 and 5 mm, the sample holder cell (4) has a length (B) of between 10 and 30 mm and thickness (C) of between 0.4 to 0.8 mm,
and wherein said capillary is a capillary made in a continuous manner, i.e. it does not contain any discontinuities in its material nor parts which can be repeatedly detached and reattached.

9. The flat cell capillary according to claim 8, wherein the length (B) of the sample holder cell (4) is in the range from 15 to 25 mm and the thickness (C) of the sample holder cell (4) is in the range from 0.5 to 0.7 mm.

10. The flat cell capillary according to claim 9 wherein the length (B) of the sample holder cell (4) is 20 mm and the thickness (C) of the sample holder cell (4) is 0.6 mm.

11. The flat cell capillary according to any of claims 8 to 10, wherein the volume of the sample holder cell ranges from 60 to 100 µL.

12. The flat cell capillary according to any of claims 8 to 11, wherein the length of the inlet part (2) is at least 125 mm, and the length of the outlet part (3) is at least 5 mm.

13. System for *in vivo* EPR measurements comprising a flat cell capillary as defined in any of claims 8 to 12 and a model organism introduced into that flat cell capillary.

## Patentansprüche

1. Ein Verfahren zur Durchführung einer *In-vivo-*ESR-Messung, das die folgenden Schritte umfasst:
a) Einbringen eines lebenden aquatischen Modellorganismus in eine Versuchslösung in einer Flachkapillare, sodass der Modellorganismus im flachen Teil der Flachkapillare fixiert wird;
b) Einbringen der befüllten Kapillare aus dem Schritt (a) in ein ESR-Spektrometer, sodass bei einer *In-vivo-*ESR-Messung ein Signal vom flachen Teil der Flachkapillare erfasst wird;
c) Durchführen einer *In-vivo-*ESR-Messung und Erfassen des vom Modellorganismus gesendeten Signals, der im flachen Teil der Flachkapillare fixiert ist,
wobei die ESR-Messung bei Raumtemperatur durchgeführt wird, und
wobei die Flachkapillare (1) eine im kontinuierlichen Verfahren hergestellte Kapillare in Form eines länglichen zylindrischen Rohrs ist, das einen Einlauf- (2) und einen Auslaufabschnitt (3) aufweist, d.h. sie enthält weder Unstetigkeiten in ihrem Material noch Teile, die wiederholt abgenommen und wieder angebracht werden können, wobei zwischen dem Einlauf- (2) und dem Auslaufabschnitt (3) des Rohrs ein abgeflachter Abschnitt (4) herausgebildet ist, der eine Probenhaltezelle bildet,
wobei der Einlauf- (2) und der Auslaufabschnitt (3) des Rohrs einen Innendurchmesser (A) von 4 bis 5 mm und die Probenhaltezelle (4) eine Länge (B) von 10 bis 30 mm und eine Dicke (C) von 0,4 bis 0,8 mm aufweisen.

2. Das Verfahren nach Anspruch 1, wobei die Größe des Rohrs und der Probenhalterzelle das Überleben des Modellorganismus beim Einbringen des Modellorganismus in die Kapillare, während der ESR-Messung sowie nach Abschluss der Messung erlaubt.

3. Das Verfahren nach Anspruch 1 oder 2, wobei das Volumen der Probenhalterzelle im Bereich von 60 bis 100 µl, bevorzugt von 70 bis 90 µl, und noch bevorzugter bis etwa 80 µl liegt.

4. Das Verfahren nach einem der Ansprüche 1 bis 3, wobei der Schritt (a) die folgenden Teilschritte umfasst:
aa) Einbringen der Versuchslösung in die Flachkapillare (1);
ab) Abdichten des Auslaufabschnitts (3) der Flachkapillare (1);
ac) Einbringen des Modellorganismus direkt über die Versuchslösung in den Einlaufabschnitt (2) der Flachkapillare (1);
ad) Verbringen des Modellorganismus in den Probenhalter (4) der Flachkapillare (1) durch langsames Drehen oder Schütteln; sowie
ae) Entfernen der überschüssigen Versuchslösung.

5. Das Verfahren nach einem der Ansprüche 1 bis 4, wobei das Verfahren einen weiteren Schritt umfasst, bei dem der Modellorganismus vor der *In-vivo-*ESR-Messung mit einer Spin-Versuchslösung inkubiert wird.

6. Das Verfahren nach einem der Ansprüche 1 bis 5, wobei der Modellorganismus aus einer Gruppe ausgewählt wird, die *Danio rerio, Daphnia, Lymnaea stagnalis, Tigriopus, Artemia salina* und *Gasterosteus aculeatus* umfasst.

7. Verwendung des Verfahrens gemäß einem der Ansprüche 1 bis 6 zur Bestimmung biologischer und/oder physikalischer Parameter des Modellorganismus,
wobei die biologischen und/oder physikalischen Parameter des Modellorganismus den Melanin-Radikale-Spiegel, die Membranfluidität und die Konzentration von kurzlebigen freien Radikalen umfassen.

8. Eine Flachkapillare für die *In-vivo*-ESR-Messungen in Form eines länglichen zylindrischen Rohrs mit einem Einlauf- und einem Auslaufabschnitt, wobei sich zwischen dem Einlauf- und dem Auslaufabschnitt des Rohrs ein abgeflachter Abschnitt befindet, der eine Probenhaltezelle bildet, **dadurch gekennzeichnet, dass** der Einlauf- (2) und der Auslaufabschnitt (3) des Rohrs einen Innendurchmesser (A) zwischen 4 und 5 mm, die Probenhalterzelle (4) eine Länge (B) zwischen 10 und 30 mm und eine Dicke (C) zwischen 0,4 und 0,8 mm aufweisen,
und wobei es sich bei der Kapillare um eine im kontinuierlichen Verfahren hergestellte Kapillare handelt, d.h. sie enthält weder Unstetigkeiten in ihrem Material noch Teile, die wiederholt abgenommen und wieder angebracht werden können.

9. Die Flachkapillare nach Anspruch 8, wobei die Länge (B) der Probenhalterzelle (4) im Bereich von 15 bis 25 mm und die Dicke (C) der Probenhalterzelle (4) im Bereich von 0,5 bis 0,7 mm liegt.

10. Die Flachkapillare nach Anspruch 9, wobei die Länge (B) der Probenhalterzelle (4) 20 mm und die Dicke (C) der Probenhalterzelle (4) 0,6 mm beträgt.

11. Die Flachkapillare nach einem der Ansprüche 8 bis 10, wobei das Volumen der Probenhalterzelle zwischen 60 und 100 µl liegt.

12. Die Flachkapillare nach einem der Ansprüche 8 bis 11, wobei die Länge des Einlaufabschnitts (2) mindestens 125 mm und die Länge des Auslaufabschnitts (3) mindestens 5 mm beträgt.

13. System für *In-vivo*-ESR-Messungen, das eine Flachkapillare gemäß einem der Ansprüche 8 bis 12 und einen in diese Flachkapillare eingebrachten Modellorganismus umfasst.

## Revendications

1. Procédé de réalisation d'une mesure RPE *in vivo,* comprenant les étapes suivantes :
a) introduction d'un organisme modèle aquatique vivant dans une solution d'échantillon dans un capillaire à cellule plate, de sorte que l'organisme modèle soit immobilisé dans la partie plate du capillaire à cellule plate ;
b) insertion du capillaire rempli de l'étape (a) dans un spectromètre RPE, de sorte que, pendant une mesure RPE *in vivo,* un signal provenant de la partie plate du capillaire à cellule plate soit enregistré ;
c) réalisation d'une mesure RPE *in vivo* et détection du signal provenant de l'organisme modèle immobilisé dans la partie plate du capillaire à cellule plate,
dans lequel la mesure RPE est effectuée à température ambiante, et
dans lequel le capillaire à cellule plate (1) est un capillaire réalisé de manière continue, c'est-à-dire qu'il ne présente aucune discontinuité dans sa matière ni de pièces qui pouvant être détachées et rattachées à plusieurs reprises, sous la forme d'un tube cylindrique allongé, comportant une partie d'entrée (2) et une partie de sortie (3), une partie aplatie (4), formant une cellule porte-échantillon, étant disposée entre les parties d'entrée (2) et de sortie (3) du tube,
dans lequel les parties d'entrée (2) et de sortie (3) du tube présentent un diamètre intérieur (A) de 4 à 5 mm, et la cellule porte-échantillon (4) présente une longueur (B) de 10 à 30 mm et une épaisseur (C) de 0,4 à 0,8 mm.

2. Procédé selon la revendication 1, dans lequel les dimensions du tube et de la cellule porte-échantillon assurent la vitalité de l'organisme modèle pendant l'étape d'insertion de l'organisme modèle dans le capillaire, pendant la mesure RPE et après l'achèvement de la mesure.

3. Procédé selon la revendication 1 ou 2, dans lequel le volume de la cellule porte-échantillon est compris dans la gamme de 60 à 100 µL, de préférence de 70 à 90 µL, et plus préférablement est d'environ 80 µL.

4. Procédé selon l'une quelconque des revendications 1 à 3, dans lequel l'étape (a) comprend les sous-étapes suivantes :
aa) placement de la solution d'échantillon dans le capillaire à cellule plate (1) ;
ab) scellement de la partie de sortie (3) du capillaire à cellule plate (1) ;
ac) placement de l'organisme modèle juste au-dessus de la solution d'échantillon, dans la partie d'entrée (2) du capillaire à cellule plate (1) ;
ad) déplacement de l'organisme modèle dans la cellule porte-échantillon (4) du capillaire à cellule plate (1) par rotation lente ou agitation ; et
ae) élimination de la solution d'échantillon excédentaire.

5. Procédé selon l'une quelconque des revendications 1 à 4, dans lequel le procédé comprend en outre une étape supplémentaire d'incubation de l'organisme modèle avec une solution de sonde de spin avant la mesure RPE *in vivo.*

6. Procédé selon l'une quelconque des revendications 1 à 5, dans lequel l'organisme modèle est choisi parmi un groupe comprenant *Danio rerio, Daphnia, Lymnaea stagnalis, Tigriopus, Artemia salina* et *Gasterosteus aculeatus.*

7. Utilisation du procédé selon l'une quelconque des revendications 1 à 6 pour la détermination de paramètres biologiques et/ou physiques de l'organisme modèle,
dans lequel les paramètres biologiques et/ou physiques de l'organisme modèle comprennent le niveau de radicaux de mélanine, la fluidité membranaire et le niveau de radicaux libres à courte durée de vie.

8. Capillaire à cellule plate pour des mesures RPE *in vivo,* sous la forme d'un tube cylindrique allongé comportant une partie d'entrée et une partie de sortie, une partie aplatie formant une cellule porte-échantillon étant disposée entre les parties d'entrée et de sortie du tube, **caractérisé en ce que** les parties d'entrée (2) et de sortie (3) du tube présentent un diamètre intérieur (A) compris entre 4 et 5 mm, la cellule porte-échantillon (4) présente une longueur (B) comprise entre 10 et 30 mm et une épaisseur (C) comprise entre 0,4 et 0,8 mm,
et dans lequel ledit capillaire est un capillaire réalisé de manière continue, c'est-à-dire qu'il ne présente aucune discontinuité dans sa matière ni de pièces qui pouvant être détachées et rattachées à plusieurs reprises.

9. Capillaire à cellule plate selon la revendication 8, dans lequel la longueur (B) de la cellule porte-échantillon (4) est comprise dans la gamme de 15 à 25 mm et l'épaisseur (C) de la cellule porte-échantillon (4) est comprise dans la gamme de 0,5 à 0,7 mm.

10. Capillaire à cellule plate selon la revendication 9, dans lequel la longueur (B) de la cellule porte-échantillon (4) est de 20 mm et l'épaisseur (C) de la cellule porte-échantillon (4) est de 0,6 mm.

11. Capillaire à cellule plate selon l'une quelconque des revendications 8 à 10, dans lequel le volume de la cellule porte-échantillon est compris entre 60 et 100 µL.

12. Capillaire à cellule plate selon l'une quelconque des revendications 8 à 11, dans lequel la longueur de la partie d'entrée (2) est d'au moins 125 mm et la longueur de la partie de sortie (3) est d'au moins 5 mm.

13. Système pour des mesures RPE *in vivo* comprenant un capillaire à cellule plate tel que défini dans l'une quelconque des revendications 8 à 12 et un organisme modèle introduit dans ledit capillaire à cellule plate.
